Europäisches Patentamt

European Patent Office

Office européen des brevets

(11) Publication number: 0 261 647
A2

(12) **EUROPEAN PATENT APPLICATION**

(21) Application number: 87113852.5

(22) Date of filing: 22.09.87

(51) Int. Cl.⁴: C30B 11/00 , C30B 29/48

(30) Priority: 26.09.86 JP 226366/86
01.07.87 JP 162531/87

(43) Date of publication of application:
30.03.88 Bulletin 88/13

(84) Designated Contracting States:
DE FR GB

(71) Applicant: NIPPON MINING COMPANY
LIMITED
12-32, Akasaka 1-chome Minato-ku
Tokyo(JP)

(72) Inventor: Hirata, Kazuto Nippon Mining Co.
Ltd.
Electr. Material-Component Res. Div. 17-35
Niizo
Minami 3-chome Toda-City Saitama Pref.(JP)
Inventor: Imura, Kimihiko Nippon Mining Co.
Ltd.
Electr. Material-Component Res. Div. 17-35
Niizo
Minami 3-chome Toda-City Saitama Pref.(JP)
Inventor: Oda, Osamu Nippon Mining Co. Ltd.
Electr. Material-Component Res. Div. 17-35
Niizo
Minami 3-chome Toda-City Saitama Pref.(JP)

(74) Representative: Schwan, Gerhard, Dipl.-Ing.
Elfenstrasse 32
D-8000 München 83(DE)

(54) High resistivity CdTe crystal and process for producing the same.

(57) A high-resistivity CdTe single crystal is provided wherein atomic ratio of Cd/Te is Te excessive and containing not more than 0.7 ppm (weight) In. As a process for its production, a process is provided which involves heating and cooling of a crystal-growing ampul to allow the growth of a CdTe single crystal held therein, characterized in that In as an impurity is added in an amount up to 1 ppm (by weight) in concentration.

EP 0 261 647 A2

# High-resistivity CdTe crystal and process for producing the same

## TECHNICAL FIELD

This invention relates to a high-resistivity CdTe single crystal and a process for producing the same, and more specifically to a technique for producing a high-resistivity CdTe single crystal in a simpler way than heretofore. In accordance with the invention, the enhancements in functions of the devices using high-resistivity CdTe crystals, for example, radiation detectors, Pockels cells (electro-optical modulating device), etc. can be realized.

## BACKGROUND ART

High-resistivity CdTe single crystals having a high resistivity of not less than $10^9$ $\Omega$cm have been recently necessitated for the application to radiation detectors. Further, in Pockels cells, high-resistivity CdTe single crystals having a resistivity of not less than $10^6$ $\Omega$cm have been required.

As methods for producing high-resistivity CdTe single crystal, there have been proposed a modified vertical Bridgeman method involving Cd vapor pressure control, THM (traveling heater method) etc.. For example, Cℓ-doped CdTe crystal produced in THM has lately been put to practical use.

These methods are intended to control the evaporation of easily vaporizable Cd and thereby prevent the development of Cd vacancies in the crystal. According to THM, for example, synthesized CdTe polycrystal, Te or Cd, and, in case of necessity, Cd for vapor pressure control are sealed in an evacuated fused quartz ampul. The ampul is placed in a furnace with a preset temperature distribution, and the ampul is lowered or the furnace is raised so that the CdTe once melted in molten Te is recrystalized as single crystals. The method involves a low rate of crystal growth, requires a special ampul, and calls for complex temperature control for the heating furnace, rendering the process as a whole difficult to operate. Further, its yield is poor. Generally the same also applies to the modified Bridgeman method.

## OBJECT OF THE INVENTION

To object of this invention is to establish a process for producing a high-resistivity CdTe single crystal by the use of a commonly employed single crystal-growing equipment but in a simpler way.

## SUMMARY OF THE INVENTION

The present inventors have made extensive and intensive studies in order to achieve the above aim. As a result it has now been found that the growth of a high-resistivity CdTe crystal with high quality which has not previously been obtainable is made possible by

1) using In as a dopant and limiting the concentration of In to be added as the impurity to 1 ppm (by weight) or less so that the concentration of In in a crystal produced is 0.7 ppm or less which means that the concentration of the impurity in the crystal is small enough to ignore its adverse effects in the fabrication procedure of a device, and

2) using a compositional (atomic) ratio of Cd and Te starting materials, in terms of Cd/Te ratio, in the range of 0.998 to 1.002, so that CdTe single crystal is made to be Te-excessive.

Generally, in the doping practice, a large amount of an impurity in excess of 1 ppm (by weight) can adversely affect the properties of the single crystal and hamper the fabrication of devices using such crystals. The addition of In with 1 ppm (by weight) or less, on the other hand, results in an In concentration of about 0.7 ppm (by weight) or less in the CdTe single crystal produced, or an impurity concentration low enough to reduce the unfavorable effect upon the device fabrication to a negligible level. Thus, it has just been found that when the two requirements, viz., the use of excess Te and the addition of a trace amount of In as an impurity, are combinedly met, a novel high-resistivity CdTe single crystal can be simply produced by the use of a fused quartz ampul and a heating furnace of conventional designs.

The present invention thus provides

1) A high-resistivity CdTe single crystal wherein atomic ratio of Cd/Te is Te excessive and containing not more than 0.7 ppm (weight) In, and

2) A process for producing a high-resistivity CdTe crystal which involves heating and cooling of a crystal-growing ampul to allow the growth of a CdTe single crystal held therein, characterized in that In as an impurity is added in an amount up to 1 ppm (by weight) in concentration.


## DESCRIPTION OF THE PREFERRED EMBODIMENT

Ordinary CdTe single crystals are formed in the following way. An electric furnace having a preset temperature distribution, with high-temperature, transition, and low-temperature regions, and a starting material-holding ampul placed therein are vertically moved relative to each other. The relative movement allows the materials to melt in the high-temperature region of the furnace and the resulting melt to solidify gradually to a single crystal. In the vertical Bridgeman method the ampul is lowered, whereas in the vertical gradient freezing method, the temperature of the furnace is lowered. Cd and Te starting materials are weighed beforehand to a target formulation and are charged together into a fused quartz ampul and vacuum-sealed.

As has been stated in connection with the prior art, high-resistivity CdTe single crystals to which this invention pertains have hitherto been made using a special furnace and ampul structure because difficulties attend the manufacture by such ordinary crystallizing equipment as described above. The present invention needs no special equipment but can depend on a simple crystallizer that heats and cools a CdTe single crystal-growing ampul, as typified by the vertical Bridgeman or vertical gradient freezing technique, for the formation of a high-resistivity CdTe single crystal.

According to the invention, at the time of weighing the Cd and Te materials, the amounts of the both are adjusted so that excess Te is present in the resulting CdTe single crystal. The vapor pressure of Cd at 1092°C, the melting point of CdTe, is of the order of 1 atm., or approximately 10 times that of Te. This causes evaporation of Cd into the empty part of the ampul during the crystal growth. Then, when the stoichiometry of starting material to be charged into the ampul is within the range of 0.998 to 1.002, the Cd evaporation results in a single crystal with excess Te. The amount of Cd that evaporates depends on the size and shape of the ampul, temperature and vacuum conditions, and so forth. Whatever the conditions, the end of the invention is attained by providing excess Te in the finally formed CdTe single crystal.

In, as an impurity, is added in an amount of 1 ppm (by weight) or less to the combined amount of the starting material Cd and Te. It is known that In acts as a donor that compensates for Cd vacancies in the formation of a CdTe single crystal. Excessive In, however, tends to reduce the mobility of the resulting CdTe single crystal or produce other unfavorable effects. Under the invention, the impurity In is added in a trace amount of 1 ppm (by weight) or less, preferably between 0.2 and 0.6 ppm (by weight). When added at a concentration within this range, the impurity In will show a concentration in the CdTe single crystal of about 0.7 ppm or less, at which the possibility of afore-said unfavorable outcomes can be disregarded.

Further, by limiting In concentration in the crystal to 0.1 ppm (by weight), such impurity concentration assures that it is enough low so that its adverse effects in the procedure of device fabrication may be more completely disregarded.

Thus, the combination of excess Te and trace In addition gives birth to CdTe single crystals with resistivity as high as $5 \times 10^7$ -$10^9$, preferably $10^8$ to $10^9$ $\Omega$cm, as will be clear from example to be given later. Since this high resistivity region is maintained almost entirely throughout the upper, middle, and lower portions of the single crystal, a substrate or other member can be cut off from the crystal in a high yield.

While the invention has been described in conncetion with CdTe alone, it is generally applicable to the occasions where one of the constituent elements of a compound semiconductor, as of CdTe, has a higher vapor pressure and tends to produce vacancies in the single crystal which acts as donors or acceptors electrically. It should be obvious to those skilled in the art that the invention is equally applicable to the compound semiconductors in Groups II-VI of the periodic table, e.g., CdTe, HgCdTe, ZnTe, HgTe, and CdSe, and further to the semiconductors of Group III-V compounds of this character.

A high-resistivity CdTe single crystal can now be produced in a simpler way than heretofore. The concentration of impurity In in the CdTe single crystal is limited to about 0.7 ppm (by weight) or below, preferably 0.1 ppm or below which is in the same level as the residual impurity concentration in a crystal to which no impurity has been added intentionally. In this way, a high-resistivity crystal has now been successfully realized. The single crystal of the invention is anticipated to contribute greatly to the improvement in performance of the devices using the same, for example, radiation detectors, Pockels cells, etc.

## Examples

Crystal-growing ampuls of a fused quartz having an inside diameter of 2 inches were filled with Cd and Te, In was added in varying amounts to give the concentrations shown in Table I, and then the ampuls were evacuated and sealed.

The ampul was placed in an electric furnace having an upper-stage section preset to 1150°C and a lower-stage section set to 800°C, and crystal growth was carried out in conformity with the vertical Bridgeman method. According to the method, the rate of ampul descent was set to be 1 mm/hr and the temperature gradient to 3°C/cm.

The CdTe single crystal thus formed contained excess Te owing to the Cd evaporation as described earlier. The 2-in-dia. CdTe single crystal so obtained was subjected to In concentration analyses and resistivity measurements. The results are given in Table I. The CdTe single crystal of Lot C produced in accordance with the present invention showed resistivity as high as $5 \times 10^7$ to $10^9$ Ωcm in almost all portions and an In concentration of about 0.7 ppm (by weight) or less. It was a single crystal with a higher resistivity than the crystals of Lot A and Lot B.

Similar results were obtained with CdTe single crystals produced using the gradient freezing technique. Further, 3-in-dia. CdTe single crystals gave much the same results. Lot D exhibits more excellent properties.

## Table I

|  | Lot | Qty of In added (ppmw) | Anal. value of In (ppmw) | Resistivity [Ωcm] |
|---|---|---|---|---|
| Compara. | A | 12 | 1 – 8 | $10^3 - 10^4$ |
| examples | B | 3 | 0.7 – 4.0 | $10^6$ |
| Inventive | C | 1 | 0.1 – 0.7 | $5 \times 10^7 - 10^9$ |
| examples | D | 0.3 | 0.03 – 0.1 | $10^8 - 10^9$ |

## Claims

1) A high-resistivity CdTe single crystal wherein atomic ratio of Cd/Te is Te excessive and containing not more than 0.7 ppm (weight) In.

2) A process for producing a high-resistivity CdTe crystal which involves heating and cooling of a crystal-growing ampul to allow the growth of a CdTe single crystal held therein, characterized in that In as an impurity is added in an amount up to 1 ppm (by weight) in concentration.

3) A process according to claim 1 wherein the amounts of Cd and Te starting materials are such that the Cd/Te atomic ratio ranges from 0.998 to 1.002.